Europäisches Patentamt

(19) European Patent Office

Office européen des brevets

(11) Publication number: **0 100 160 B1**

(12) **EUROPEAN PATENT SPECIFICATION**

(45) Date of publication of patent specification: 06.09.89

(51) Int. Cl.⁴: **G 11 C 11/40, H 03 K 17/292**

(21) Application number: 83303859.9

(22) Date of filing: 01.07.83

(54) **Semiconductor memory devices with word line discharging circuits.**

(30) Priority: 02.07.82 JP 116055/82
29.12.82 JP 233779/82

(43) Date of publication of application:
08.02.84 Bulletin 84/06

(45) Publication of the grant of the patent:
06.09.89 Bulletin 89/36

(84) Designated Contracting States:
DE FR GB

(56) References cited:
EP-A-0 025 316
US-A-4 156 941
US-A-4 168 490

IEEE INTERNATIONAL SOLID-STATE CIRCUITS
CONFERENCE, February 1978, pages 98,99,

IEEE, New York, US; A. HOTTA et al.: "THAM
9.1: A high-speed low-power 4096x 1-bit
bipolar RAM

(73) Proprietor: FUJITSU LIMITED
1015, Kamikodanaka Nakahara-ku
Kawasaki-shi Kanagawa 211 (JP)

(72) Inventor: Okajima, Yoshinori
Fujitsu Dai-3 Fujigaoka-ryo 1, Fujigaoka 2-chome
Midori-ku Yokohama-shi Kanagawa 227 (JP)

(74) Representative: Fane, Christopher Robin King
et al
HASELTINE LAKE & CO. Hazlitt House 28
Southampton Buildings Chancery Lane
London, WC2A 1AT (GB)

## Description

The present invention relates to semiconductor memory devices.

Due to recent developments made in the technology of semiconductor memory devices, it has become necessary to increase the degree of integration, and to decrease the chip size, of high-speed bipolar semiconductor memory devices and metal-oxide semiconductor (MOS) memory devices. The degree of integration of a MOS can be increased easily, but that of a high-speed bipolar RAM device cannot. A high-speed bipolar RAM device is used especially as a working register in a central, processing unit (CPU) of a large-scale electronic computer, for example, and is arranged in a high position in a memory hierarchy structure including low-speed, high-capacity memory devices and high-speed, low-capacity memory devices, i.e. in a position near to an arithmetic circuit. A general-purpose, large-scale computer tends to use a parallel processing system or a multi-processing system, and the CPU thereof tends to be highly functional. In a CPU of future large-scale computers, it will be essential to integrate therein working registers at a high density. Therefore, it is necessary to increase the degree of integration of a bipolar RAM device while retaining the high-speed quality thereof. In a bipolar static RAM device, each of the static-type memory cells connected to word lines of the device constitutes a form of capacitive load on the word lines. Therefore, it is necessary to use word-line discharging circuits, each of which extracts a discharging current from a word line having a low potential so that electric charges are removed from the memory cells connected to a word line having a high potential when the word line having a high potential changes from a selected state to a non-selected state. It is also important that the degree of integration of the discharging circuits be large.

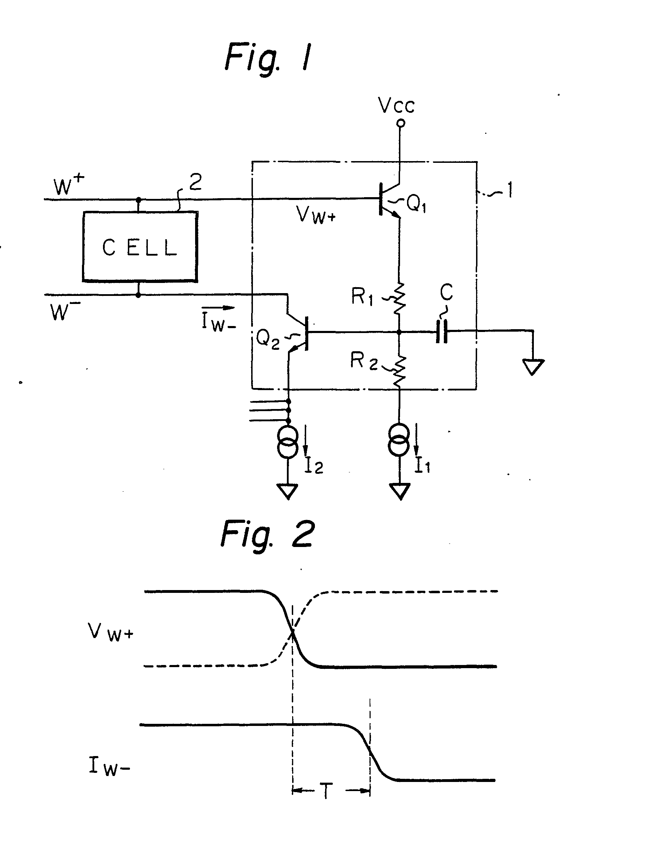

As illustrated in Fig. 1 of the accompanying drawings, a known word-line discharging circuit 1 uses a capacitor C having a large capacitance and resistors $R_1$ and $R_2$ having a large resistance. A discharging current flows for a predetermined period of time and is controlled by discharging the electric charges stored in the capacitor C through the resistors $R_1$ and $R_2$. In the discharging circuit 1 of Fig. 1, a word line $W^+$, having a high potential and being connected to a static-type memory cell 2 of a static RAM device, is connected to the base of an emitter-follower transistor $Q_1$, whose collector is connected to a high-voltage terminal of a voltage source $V_{CC}$. The emitter of the transistor $Q_1$ is connected to a constant-current source $I_1$ via the resistors $R_1$ and $R_2$. The common connecting point of a series connection of the resistors $R_1$ and $R_2$ is connected to a terminal of the capacitor C having a large capacitance. Another terminal of the capacitor is connected to a low-voltage terminal of the voltage source $V_{CC}$. The common connecting point of the resistors $R_1$ and $R_2$ is also connected to the base of a discharging transistor $Q_2$. The collector of the transistor $Q_2$ is connected to a word line $W^-$ having a low potential and being connected to the memory cells 2, and the emitter thereof is connected to a constant-current source $I_2$ for discharging a current. A discharging circuit of this type is known from EP—A—0025316.

In such a known discharging circuit using a capacitor C and resistors $R_1$ and $R_2$, when the word line $W^+$ having a high potential changes from a selected state to a non-selected state, i.e. when the potential $V_{W+}$ of the word line $W^+$ changes from high to low as illustrated in Fig. 2 of the accompanying drawings, the potential of the base of the discharging transistor $Q_2$ does not change from high to low immediately. That is, in such a transient state, since a constant current flows through the emitter of the emitter-follower transistors $Q_1$ into the constant current source $I_1$, the potential of the emitter thereof is always lower than the potential of the word line $W^+$ by a base-emitter forward-biased voltage of 0.8 V so that the potential of the emitter thereof falls immediately. However, the potential of the common connecting point of the resistors $R_1$ and $R_2$, i.e. the base of the discharging transistor $Q_2$, does not fall immediately because the capacitor C having a large capacitance is connected thereto. The potential of the base of the transistor $Q_2$ falls after the electric charges stored in the capacitor C are discharged through the resistors $R_1$ and $R_2$. Therefore, the collector current of the discharging transistor $Q_2$, i.e. the discharging current $I_{w-}$, continues to flow for a short time when the transistor $Q_2$ is in a turned-on state after the word line $W^+$ having a high potential has changed from high to low, as illustrated in Fig. 2. The discharging current from the word line $W^-$ is cut off when the transistor $Q_2$ changes from a turned-on state to a turned-off state after a delay time T determined by the time constant of the discharging circuit. The known discharging circuit which operates in the above-mentioned manner uses a capacitor having a large capacitance and resistors having a large resistance. Therefore, if it is necessary to increase the time constant of the discharging circuit, the area occupied by the discharging circuit on a semiconductor chip becomes large, with the result that it is difficult to increase the degree of integration of a memory device using discharging circuits.

According to a first aspect of the present invention there is provided a semiconductor memory device comprising:

a plurality of sets of static-type memory cells;

a plurality of pairs of word-lines, which pairs are connected respectively to the said sets of memory cells, one of the lines of each pair being operated at a high potential than the other when the device is in use; and

word-line discharging circuitry including a plurality of individual circuit portions connected respectively with the word-line pairs and operable to discharge selected word-line pairs by maintaining a connection between a constant-current or constant-voltage source and a line of each selected pair for a period determined by charge or discharge of a capacitance provided in the device;

- characterised in that said individual circuit portions comprise respective thyristors, and in that the said capacitance is provided for each word-line pair by intrinsic capacitance of the thyristor connected therewith, each such thyristor being constructed and connected so as to comprise a PNP transistor, having an emitter connected to said one word-line, and an NPN transistor, having a collector and a base connected to the respective base and collector of the said PNP transistor, an emitter connected to the said constant-current or constant-voltage source, and an additional collector or additional emitter connected to the said other word-line.

According to a second aspect of the present invention there is provided a semiconductor memory device comprising:

a plurality of sets of static-type memory cells;

a plurality of pairs of word lines, which pairs are connected respectively to the said sets of memory cells, one of the lines of each pair being operated at a higher potential than the other when the device is in use; and

word-line discharging circuitry including a plurality of individual circuit portions connected respectively with the word-line pairs and operable to discharge selected word-line pairs by maintaining a connection between a constant-current or constant-voltage source and a line of each selected pair for a period determined by charge or discharge of a capacitance provided in the device;

characterised in that the said individual circuit portions comprise respective thyristors, and in that the said capacitance is provided for each word-line pair by intrinsic capacitance of the thyristor connected therewith, each such thyristor being constructed and connected so as to comprise a PNP transistor, having an emitter connected to the said one word-line, and a first NPN transistor, having a collector and a base connected to the respective base and collector of the said PNP transistor and an emitter connected to the said constant-current or constant-voltage source, the device being further characterised in that each of the said individual circuit portions further comprises a second NPN transistor having a base connected to the base of the said first NPN transistor of the circuit portion concerned, an emitter connected to an additional constant-current or constant-voltage source of the device, and a collector connected to the said other word-line.

Word-line discharging circuitry embodying the present invention can be made so as to occupy a smaller area on a semiconductor chip, thereby permitting a greater degree of integration, than prior art discharging circuitry.

Furthermore, an embodiment of the second aspect of the present invention can allow the respective discharging currents from the high and low potential word-lines $W^+$, $W^-$ to be determined independently of one another.

Reference will now be made, by way of example, to the accompanying drawings, in which:

Figure 1 (described above) shows known word-line discharging circuitry;

Figure 2 (described above) is a waveform diagram illustrating the operation of the word-line discharging circuitry of Fig. 1;

Figures 3A and 3B show portions of word-line discharging circuitry embodying the first aspect of the present invention;

Figures 4A and 4B show equivalent circuits of the circuitry portions shown in Figs. 3A and 3B respectively;

Figure 5 shows word-line discharging circuitry embodying the first aspect of the present invention;

Figure 6 shows further word-line discharging circuitry embodying the first aspect of the present invention;

Figure 7 shows a semiconductor memory device embodying the first aspect of the present invention, in which the circuitry of Fig. 6 is employed;

Figure 8 shows a memory cell used in the semiconductor memory device of Fig. 7;

Figure 9 shows another semiconductor memory device embodying the first aspect of the present invention, in which the circuitry of Fig. 6 is employed;

Figure 10 shows a further semiconductor memory device embodying the first aspect of the present invention, in which the word-line discharging circuitry of Fig. 5 is employed;

Figures 11 and 12 show word-line discharging circuitry embodying the second aspect of the present invention; and

Figure 13 shows a semiconductor memory device embodying the second aspect of the present invention, in which the word-line discharging circuitry of Fig. 11 is employed.

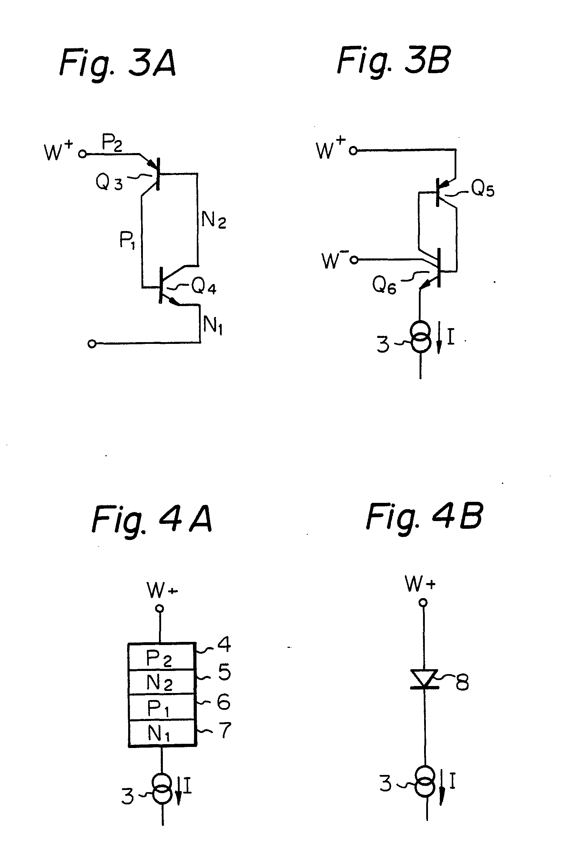

Word-line discharging circuitry embodying the present invention employs a thyristor having a four-layer PNPN structure, i.e. a silicon-controlled rectifier (SCR). The SCR has, as is illustrated in Fig. 3A, a four-layer structure $P_2N_2P_1N_1$ and is generally used as a P-gate SCR which has a gate electrode connected to the $P_1$ layer or as an N-gate SCR which has a gate electrode connected to the $N_2$ layer. The SCR having a four-layer PNPN structure is composed of two transistors $Q_3$ ($P_1N_2P_2$) and $Q_4$ ($N_1P_1N_2$) having different types of conductivity, the emitters of the transistors $Q_3$ and $Q_4$ being a $P_2$ layer and an $N_1$ layer, respectively. The collectors of the two transistors $Q_3$ and $Q_4$ are connected to the bases of the transistors $Q_4$ and $Q_3$, respectively. Therefore, the two transistors $Q_3$ and $Q_4$ constitute a positive feedback circuit. If the anode $P_2$ of the SCR is positively biased and the cathode $N_1$ thereof is negatively biased, if one of the emitter junctions is caused to be forward-biased by using the base electrode of one of the corresponding transistors and if the collector current of the corresponding transistor is large enough to saturate the other transistor, the collector junction of the other transistor is caused to be forward-biased and the SCR is switched to a turned-on state. The switching condition to turn on the SCR is $a_1 + a_2 \geq 1$, where $a_1$ and $a_2$ are current transmission factors of the transistors $Q_4$ and $Q_3$, respectively. Generally, since every PN junction has a capacitance, if a voltage v is applied between the anode electrode and the cathode electrode of an SCR, a charging current i flows from the anode to the cathode to electrically charge the capacitance c of the junction. That is, a current $i = c(dv/dt)$ flows from the anode to the cathode, and if the current i is large enough so that $a_1 + a_2$ is larger than or equal to 1, the SCR is turned on.

Figure 3B illustrates another type of PNPN element for use in a semiconductor memory device embodying the present invention. In Fig. 3B, $Q_5$ designates a PNP-type transistor whose emitter is connected to a word line $W^+$ having a high potential. The symbol $Q_6$ designates a multi-collector-type NPN transistor, one of the collectors of which is connected to a word line $W^-$ having a low potential. Reference numeral 3 designates a constant-current source through which a current I flows from the emitter of the transistor $Q_6$. The collector of the transistor $Q_5$ and the base of the transistor $Q_6$ (both electrodes are constituted by P-type semiconductor regions) are commonly connected, and the base of the transistor $Q_5$ and the other collector of the transistor $Q_6$ (both electrodes are constituted by N-type semiconductor regions) are commonly connected. Therefore, the circuit of Fig. 3B also has a PNPN-type element structure which is substantially the same as that of the thyristor of Fig. 3A.

Figure 4A illustrates the element structure of the circuit of Fig. 3A and of Fig. 3B. In Fig. 4A, 4 designates the emitter of the transistor $Q_3$ or $Q_5$, 5 designates the base of the transistor $Q_3$ or $Q_5$ connected to the collector of the transistor $Q_4$ or $Q_6$, 6 designates the collector of the transistor $Q_3$ or $Q_5$ and the base of the transistor $Q_4$ or $Q_6$, and 7 designates the emitter of the transistor $Q_4$ or $Q_6$. Generally, a thyristor is not turned on if it is not triggered. However, the direct current characteristic of the thyristor formed in an integrated circuit device is equivalent to the direct current characteristic of a diode 8 shown in Fig. 4B. This is because when a current is flowing through the thyristor, both the PNP-type transistor $Q_3$ or $Q_5$ and the NPN-type transistor $Q_4$ or $Q_6$ are saturated and the three junctions of the thyristor are all in a forward-biased state. In order to obtain a current-voltage characteristic which is equivalent to that of the diode 8, it is necessary to control the parameters of the two transistors $Q_3$ or $Q_5$ and $Q_4$ or $Q_6$ so that the parameters assume appropriate values. Control of the parameters is quite easy.

Since the SCR is electrically equivalent to a capacitor having a large capacitance when it is switched from a turned-off state to a turned-on state, embodiments of the present invention make use of this important characteristic to prolong the discharging current. That is, when the SCR is in a turned-on state, the transistors $Q_3$ and $Q_4$ or the transistors $Q_5$ and $Q_6$ are both saturated, and, therefore, each of the base-collector junctions of these transistors has a diffusion capacitance, in addition to a junction capacitance created by a depletion layer, which is large in proportion to the current flowing through the junctions. Since the PNPN structure has three junctions PN, NP, and PN and since each of these three junctions has a capacitance which is the sum of the above-mentioned junction capacitance and diffusion capacitance, the capacitance of the PNPN structure, i.e. the SCR, is large.

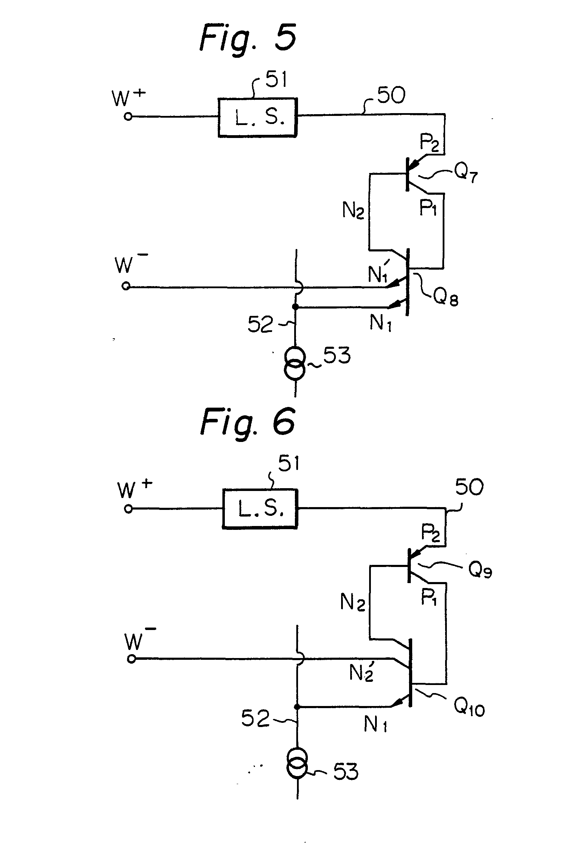

As shown in Figures 5 and 6, word-line discharging circuitry embodying the first aspect of the present invention includes individual circuit portions each of which comprises an SCR whose anode terminal 50 is connected, by a voltage level shifter 51, to a word line $W^+$ having a high potential and whose cathode terminal 52, which corresponds to the $N_1$ portion, is connected to a constant-current source 53.

In the circuit of Fig. 5, the SCR comprises a PNP transistor $Q_7$ and an NPN transistor $Q_8$, which is formed as a multi-emitter transistor. A word line $W^-$ having a low potential is connected to the second emitter terminal $N_1'$ of the transistor $Q_8$ ($N_1 P_1 N_2$).

In the circuit of Fig. 6, the SCR comprises a PNP transistor $Q_9$ and an NPN transistor $Q_{10}$, which is formed as a multi-collector transistor. The word line $W^-$ having a low potential is connected to the second collector terminal $N_2'$ of the transistor $Q_{10}$ ($N_1 P_1 N_2$).

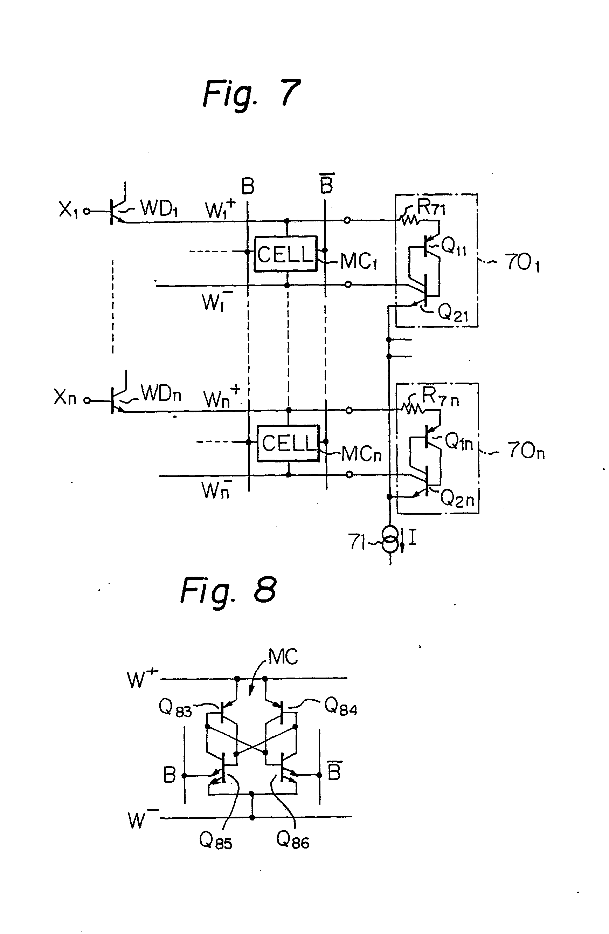

As shown in Figure 7, a semiconductor memory device embodying the first aspect of the present invention comprises: individual circuit portions (called discharging circuits hereafter) $70_1$ through $70_n$ of word-line discharging circuitry, connected respectively with the word line pairs, word line drivers $WD_1$ through $WD_n$; and saturation-type memory cells $MC_1$ through $MC_n$. Each of the PNP-type transistors $Q_{11}$ through $Q_{1n}$ of the discharging circuits $70_1$ through $70_n$ corresponds to the transistor $Q_9$ of Fig. 6, and each of the NPN-type transistors $Q_{21}$ through $Q_{2n}$ thereof corresponds to the transistor $Q_{10}$ of Fig. 6. A constant-current source 71 is provided commonly for the discharging circuits $70_1$ through $70_n$, and the emitter electrodes of the transistors $Q_{21}$ through $Q_{2n}$ are commonly connected to the constant-current source 71 so as to constitute a current-switch circuit. The symbols $R_{71}$ through $R_{7n}$ designate resistors for level shifting or voltage dropping, each of which corresponds to the voltage level shifter of Fig. 6 and which are inserted between the word line $W_1^+$ through $W_n^+$ and the emitters of the transistor $Q_{11}$ through $Q_{1n}$. Each of the memory cells $MC_1$, $MC_2$, - - - has, for example, the structure shown in Fig. 8. In Fig. 8, $Q_{83}$ and $Q_{84}$ are PNP-type load transistors, $Q_{85}$ and $Q_{86}$ are NPN-type drive transistors each having multi-emitters, and B and $\overline{B}$ are a pair of bit lines.

In the circuit of Fig. 7, assume that a selecting

signal $X_1$ is high (for example, $-0.9$ V) so that a word line $W_1{}^+$ is selected and that other selecting signals are low (for example $-1.9$ V), i.e. are in a non-selected state. In such a case, a current I of the constant-current source 71 flows only through the discharging circuit $70_1$, which is connected to the word line $W_1{}^+$ having a high potential. That is, since the potential of the word line $W_1{}^+$ is high, a current flows through the emitter-base path of the transistor $Q_{11}$. This current becomes the base current of the transistor $Q_{11}$ so that the collector current thereof flows. The collector current becomes the base current of the transistor $Q_{21}$, and the base current of the transistor $Q_{11}$ becomes the collector current of the transistor $Q_{21}$, thereby turning on the transistor $Q_{21}$. Therefore, the PNPN element constituted by the path from the emitter of the transistor $Q_{11}$ to the emitter of the transistor $Q_{21}$ is turned on. In this condition, the transistors $Q_{11}$ and $Q_{21}$ are both very saturated, with the result that the base potential of the transistor $Q_{21}$ becomes approximately equal to the emitter potential of the transistor $Q_{11}$. In the explanation, these potentials are assumed to be the same. Since the transistor $Q_{21}$ is a multi-collector transistor, a predetermined ratio, for example, 80% of the current I flowing into the constant-current source 71 flows from the second collector connected to the word line $W_1{}^-$. For example, if R=15 kilohms, the current flowing from the emitter of the transistor $Q_{11}$ is 0.4 mA. In this case, each of the discharging circuits connected to a non-selected row, for example, $70_n$, is also in a turned-on state. That is, since the discharging circuit $70_n$ is connected to a word line $W_n{}^+$ whose potential is low and since a discharging current does not flow through the discharging circuit $70_n$, the potential of the emitter of the transistor $Q_{1n}$ is approximately equal to the potential of the word line $W_n{}^+$ (i.e. $-1.9$ V). The potential of the second collector of the transistor $Q_{2n}$ is equal to the potential of the word line $W_n{}^-$ ($-2.7$ V). Therefore, the second collector of the transistor $Q_{2n}$ operates as an emitter, and a PNPN element constituted by a path from the emitter of the transistor $Q_{1n}$ to the second collector of the transistor $Q_{2n}$ is turned on. However, a PNPN element constituted by a path from the emitter of the transistor $Q_{1n}$ to the emitter of the transistor $Q_{2n}$ is in a turned-off state.

Let us consider a case in which the potential of the base ($X_1$) of the word line driver $WD_1$ of the selected column $W_1{}^+$ changes from the potential of the selected state ($-0.1$ V) to the potential of the non-selected state ($-1.1$ V). In such a condition, since the transistors $Q_{11}$ and $Q_{21}$ are saturated and slowly respond to the changes in their base potentials, the discharging current I continues to flow through these transistors for a predetermined delay time even after the base potentials thereof have changed. Thus, as is illustrated in Fig. 2, a discharging operation is continuously effected even after the word line $W_1{}^+$ has changed to a non-selected state, electric charges remaining in the word lines $W_1{}^+$ and $W_1{}^-$

and memory cell portions are coercively discharged, and the potential of the word lines $W_1{}^+$ and $W_1{}^-$ thus falls rapidly, thereby preventing double selection, i.e. selection of two word lines simultaneously. The resistors $R_{71}$ through $R_{7n}$ of Fig. 7 serve to drop the potential level of a discharging circuit connected to a selected row. If the resistors $R_{71}$ through $R_{7n}$ are not used, the second collector of the transistor $Q_{21}$ is completely forward-biased and the discharging current flows mainly through the path including the word lines $W_1{}^+$ and the transistor $Q_{11}$, with the result that the discharging current does not flow from the memory cells.

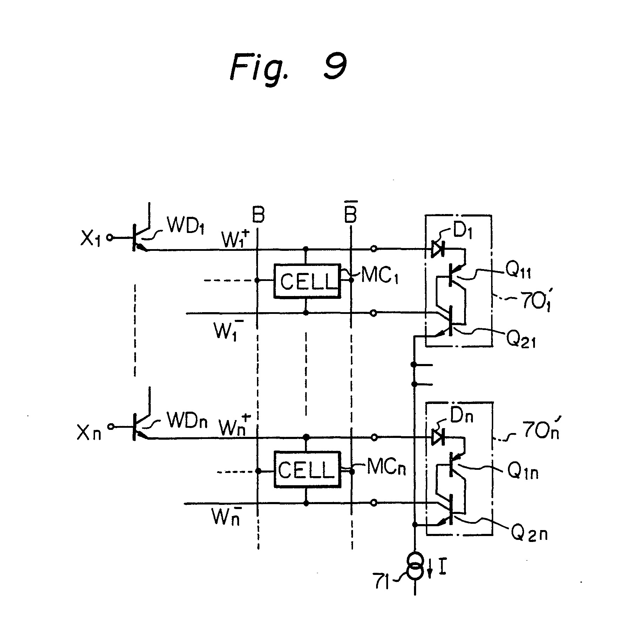

Figure 9 illustrates an embodiment of the first aspect of the present invention in which the resistors $R_{71}$ through $R_{7n}$ of the device of Fig. 7 are replaced by diodes $D_1$ through $D_n$ for level shifting. It should be noted that in this case of the PNPN elements of Fig. 9 is completely turned off in a non-selected state.

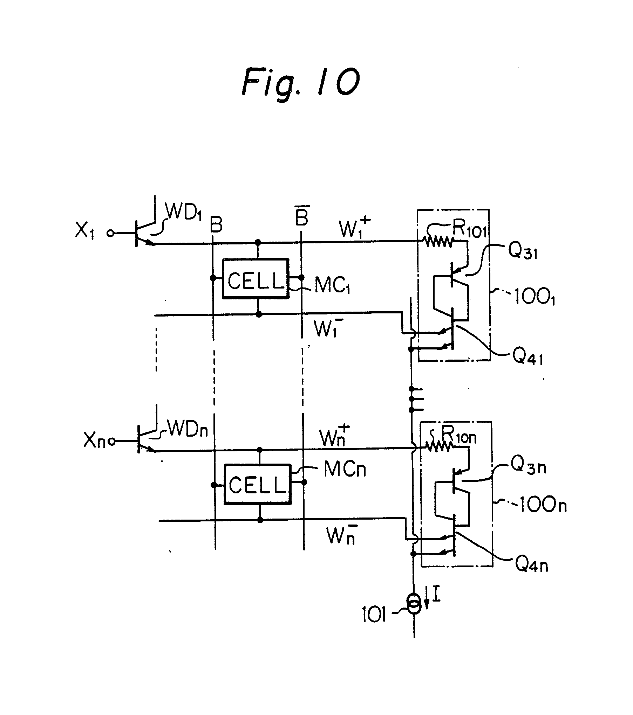

As shown in Figure 10, a further memory device embodying the first aspect of the present invention comprises discharging circuits (circuit portions) $100_1$ through $100_n$ using multi-emitter-type NPN transistors $Q_{41}$ through $Q_{4n}$ in a manner similar to the fundamental circuit of Fig. 5. In the device of Fig. 10, each of the second emitters connected to the word lines $W_1{}^-$ through $W_n{}^-$ operates as a collector. It is possible to control the quantity of a current flowing from a word line having a low potential to a constant-current source 101 by changing the current amplification factors of two emitters. The principle of operation of the circuit of Fig. 10 is the same as that of Fig. 9. In any of the above-mentioned devices, a constant-current source can be replaced by a constant-voltage source.

In devices embodying the present invention, it is not necessary to use capacitors having a large capacitance and resistors having a high resistance, with the result that the area occupied by word-line discharging circuitry on the chip can be decreased. Since, in the device of Fig. 10, PNPN elements each having a multi-emitter transistor are realized by the same structure as the memory cells, it is easy to manufacture the memory device and it is possible to change the time constant automatically in accordance with the capacitance of the memory cells.

However, in the above-mentioned discharging circuits, since the ratio between the discharging current extracted from the word line $W^+$ having a high potential and the discharging current extracted from the word line $W^-$ having a low potential is determined by the structure of the SCR, it is impossible to set the magnitudes, or the ratio, of these discharging currents to any desired values, and it can be rather difficult to design and manufacture the transistors of the SCR.

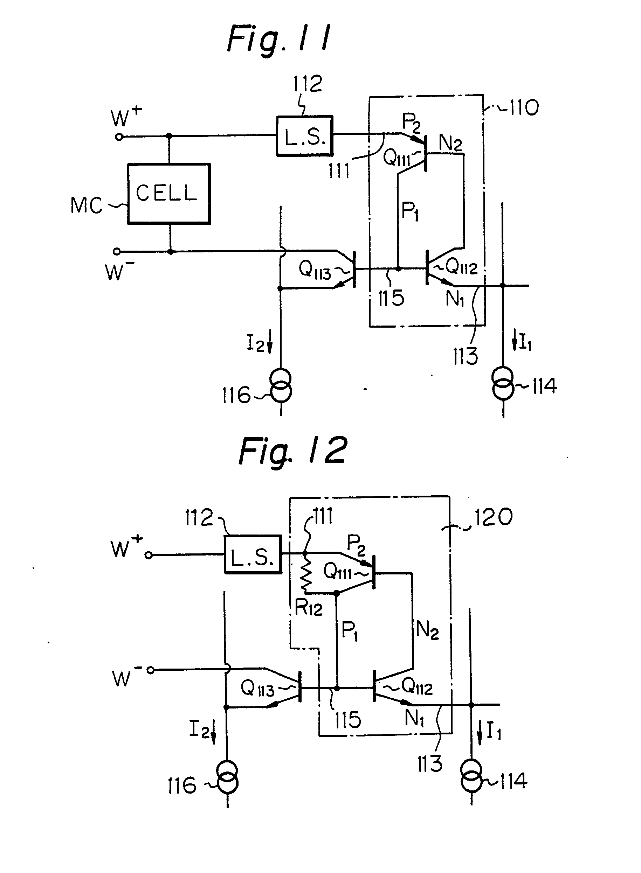

Word-line discharging circuitry shown in Figure 11 embodies a second aspect of the present invention which can avoid the above-mentioned problems. In the word-line discharging circuitry of Fig. 11, the magnitudes of the current extracted from a word line having a high potential and the current extracted from a word line having a low potential can be adjusted, i.e. the current ratio can be controlled, independently of the structure of the SCR by relying on the current values of two constant-current sources. In practice a plurality of bipolar static-type memory cells MC (of which only one is shown in Fig. 11) are connected between a word line $W^+$ having a high potential and a word line $W^-$ having a low potential. At one end of the word line $W^+$, the anode terminal 111 of an SCR 110 which is PNPN element is connected to the word line $W^+$, via a voltage level shifter 112. The cathode terminal 113 of the SCR and the cathode terminals of the SCRs corresponding to the other words (not shown) are commonly connected to a constant-current source 114.

In the embodiment shown in Fig. 11, an output terminal is attached to the $P_1$ portion 115 of the $P_2N_2P_1N_1$ element of the SCR and is connected to the base terminal of a discharging transistor $Q_{113}$. The collector of the transistor $Q_{113}$ is connected to a word line $W^-$ having a low potential, and the emitter of the transistor $Q_{113}$ and the emitters of the discharging transistors, each corresponding to the transistor $Q_{113}$, of the other word lines are commonly connected to another constant-current source 116. The SCR 110 has the four-layer structure $P_2N_2P_1N_1$, described before with reference to Fig. 3A. In word-line discharging circuitry using such a PNPN element, it is possible to prolong the discharging current extracted from the word line $W^-$ by utilizing an SCR since an SCR has a slow voltage response. That is, an SCR has a large capacitance, constituted by a junction capacitance and a diffusion capacitance, when a current flows therethrough. When a current flows through the SCR 110, the transistor $Q_{111}$ having a $P_2N_2P_1$ structure and the transistor $Q_{112}$ having an $N_2P_1N_1$ structure are both saturated, and each of the PN junctions of these transistors has not only a junction capcitance created by the depletion layer but also a diffusion capacitance which is proportional to the current flowing therethrough. When the SCR 110 is in a turned-on state, since the transistor $Q_{111}$ is saturated, the potential of the anode terminal 111 is higher than the potential of the base of the transistor $Q_{113}$ by about 0.4 V, i.e. by the potential between the collector $P_1$ and the emitter $P_2$, and the potential of the word line $W^+$ is higher than the potential of the anode terminal 111 by the voltage level shift of the voltage level shifter 112. By using such potential distribution, it is possible to create an appropriate potential difference, for example 0.8 V, between the word lines $W^+$ and $W^-$. When the word line $W^+$ having a high potential is selected by an address signal, the potential of the word line $W^+$ becomes higher and a current $I_1$ flows from the anode terminal 111 to the cathode terminal 113 of the SCR 110. In such a condition, since base current is supplied to the non-saturated transistor $Q_{113}$, the transistor $Q_{113}$ is turned on and a discharging current $I_2$ flows from the word line $W^-$ having a low potential through the collector-emitter path of the transistor $Q_{113}$. When the word line $W^+$ changes from a selected state to a non-selected state, the potential thereof changes from high to low. In such a condition, since the SCR 110 operates as a capacitor having a large capacitance, the potential of the base terminal 115 of the transistor $Q_{113}$ does not immediately fall to a low potential level but instead is maintained to keep the transistor $Q_{113}$ in a turned-on state. That is, the discharging current continues to flow from the word line $W^-$ through the collector-emitter path of the transistor $Q_{113}$ for a while. When the electric charges stored in the capacitor of the SCR 110 having a large capacitance are discharged so that it becomes impossible to supply a sufficiently large current to the base of the transistor $Q_{113}$, the transistor $Q_{113}$ is turned off and the discharging current is cut off. That is, the transistor $Q_{113}$ is in a turned-on state and the discharging current flows for a while after the word line $W^+$ has changed from a selected state to a non-selected state. When the word line $W^+$ having a high potential chages from a selected state to a non-selected state or vice versa, the discharging circuit effectively works to increase the write-in and the readout speed of the RAM device. It is necessary, in this case, to extract the discharging current from the word line $W^-$ not only at the time the potential of the word line $W^+$ changes but also after it changes. It is necessary to use a delay circuit structure to continue to extract the discharging current for a predetermined delay time and to stop the flow of the discharging current after the predetermined delay time. Word-line discharging circuitry embodying the present invention uses an SCR in a delay circuit structure therein, and in the word-line discharging circuitry it is possible to control the current ratio between the word lines $W^+$ and $W^-$. As is illustrated in the SCR discharging circuit of Fig. 11, which is different from the SCR discharging circuit of Figs. 5 and 6, the current $I_1$ of the word line $W^+$ which flows between the anode terminal 111 and the cathode terminal 113 of the SCR 110 is determined by the magnitude of the current of the constant-current source 114 ($I_1$), and the discharging current of the word line $W^-$ is independently determined by the magnitude of the current of the constant-current source 116 ($I_2$) connected to the emitter of the transistor $Q_{113}$. The discharging circuitry of Fig. 11 is an improvement over the circuits of Figs. 5 and 6 in this respect. The SCR discharging circuit of Figs. 5 and 6 has the disadvantage that the magnitude of the discharging current is determined by the structure of the transistors of the SCR and varies depending on the parameters of the SCR. However, in the SCR discharging circuit of Fig. 11, the current ratio is accurately determined. Therefore, it is possible to arrange for the current of the word line $W^+$ to be, for example, 0.5 mA and the current of the word line $W^-$ to be large, for example 1.5 mA, thereby decreasing the number of erroneous operations when a write-in or readout operation is effected and making

uniform the operating speed independent of the position of a selected word line.

As shown in Figure 12, further word-line discharging circuitry embodying the present invention comprises a resistor $R_{12}$ inserted between the emitter and the collector of a $P_2N_2P_1$ transistor $Q_{111}$ of an SCR 120. The resistor $R_{12}$ operates so as to prevent the $P_2N_2P_1$ transistor $Q_{111}$ from being turned off, thereby decreasing the delay time of the word-line discharging circuitry. Therefore, it is possible to adjust the delay time of the word-line discharging circuitry to an appropriate value by changing the resistance of the resistor $R_{12}$.

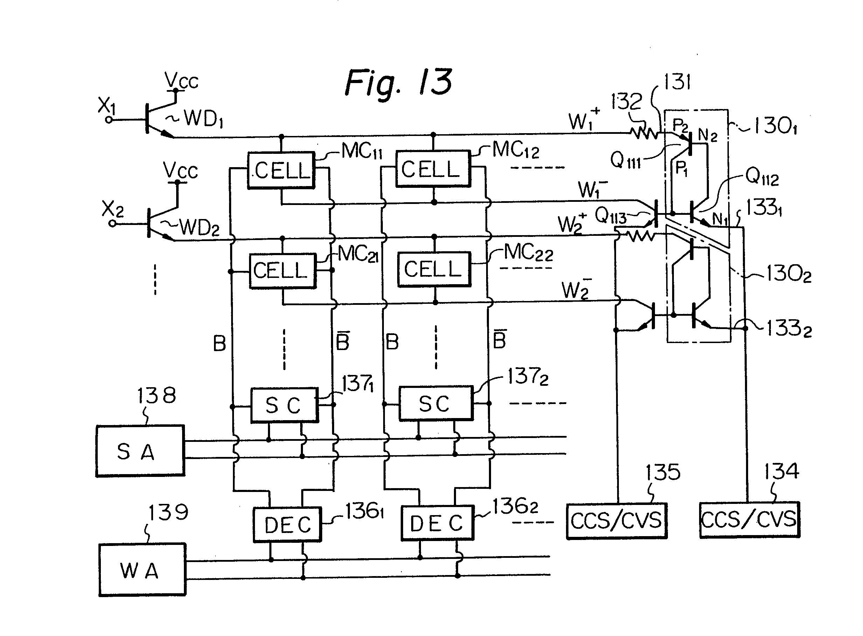

A semiconductor memory device embodying the second aspect of the present invention, in which the word-line discharging circuitry of Figure 11 is connected to a memory cell array thereof, is shown in Fig. 13.

In the circuit of Fig. 13, the base terminal of each word line driver $WD_1$, $WD_2$, - - - is connected to the output terminal of an address decoder (not shown), collector terminals thereof are connected to the terminal of a power source $V_{cc}$ having a high potential, and the emitter terminals thereof are connected to corresponding word lines $W_1^+$, $W_2^+$, - - - having high potentials. Since a plurality of bipolar-type RAM cells, for example $MC_{11}$, $MC_{12}$, - - -, arranged in rows are connected to each of the word lines $W_1^+$, $W_2^+$, - - - having a high potential, the load of each of the word lines $W_1^+$, $W_2^+$, - - - is heavy, and each of the word line drivers $WD_1$, $WD_2$, - - - is used as an emitter-follower circuit. The word line $W_1^+$ is connected to an anode terminal 131 of an SCR $130_1$ (a PNPN element) in word-line discharging circuitry via a resistor 132 used as a voltage level shifter in the aforementioned manner. A cathode terminal $133_1$ of the SCR $130_1$, together with a cathode terminal $133_2$ of an SCR $130_2$ and other cathode terminals corresponding to other word lines, is commonly connected to a constant-current source 134.

The circuit of Fig. 13 uses the discharging-circuit of Fig. 11, in which the base of the discharging transistor $Q_{113}$ is connected to the $P_1$ portion of the $P_2N_2P_1N_1$ element of the SCR. The word line $W^-$, having a low potential and being connected to the memory cells $MC_{11}$, $MC_{12}$, - - - in the first row, is connected to the collector terminal of the discharging transistor $Q_{113}$. The emitter of the transistor $Q_{113}$ is connected to another constant-current source 135, together with the emitters of the transistors each corresponding to the transistor $Q_{113}$, and to other word lines. The memory cells $MC_{11}$, $MC_{21}$, - - - disposed in the first column, the memory cells $MC_{12}$, $MC_{22}$, - - - disposed in the second column, and so on are commonly connected to corresponding pairs of bit lines B and $\overline{B}$ which are connected to bit address decoders $136_1$, $136_2$, . . . via sense circuits $137_1$, $137_2$, . . . . The bit address decoders $136_1$, $136_2$, . . . select one column of memory cells, and a row of memory cells is selected by the word address decoder, thereby permitting reading out of, or writing into, a selected memory cell. In order to control the readout and write-in operation, a sense amplifier 138 is commonly connected to the sense circuits $137_1$, $137_2$, - - -, and a write-in amplifier 139 is commonly connected to the bit address decoders $136_1$, $136_2$, - - -.

In the embodiment shown in Figure 13, it should be noted that the constant-current source 134 connected to the cathode terminals $133_1$, $133_2$, - - - of the SCRs for independently determining the magnitude of the discharging currents from the word lines $W^+$ and $W^-$, and the constant-current source 135 connected to the emitters of the discharging transistors $Q_{113}$ and so on can be replaced by constant-voltage sources.

As was mentioned above, since the word-line discharging circuitry embodying the present invention uses an SCR as a PNPN element, it is possible to delay the time when the discharging current from the word line $W^-$ is cut off after the word line $W^+$ has changed from a selected state to a non-selected state by utilizing the slow voltage response of the SCR. It is also possible to render small the area occupied by the word-line discharging circuits and to determine independently the magnitudes of the discharging current from the word line $W^+$ having a high potential and of the discharging current from the word line $W^-$ having a low potential. Therefore, embodiments of the present invention can provide a bipolar-type RAM device which does not operate erroneously, which has a high reliability, and which has a high read-out and write-in speed.

**Claims**

1. A semiconductor memory device comprising:

a plurality of sets of static-type memory cells (MC);

a plurality of pairs of word-lines (W), which pairs are connected respectively to the said sets of memory cells, one ($W^+$) of the lines of each pair being operated at higher potential than the other ($W^-$) when the device is in use; and

word-line discharging circuitry including a plurality of individual circuit portions ($70_n$) connected respectively with the word-line pairs (W) and operable to discharge selected word-line pairs (W) by maintaining a connection between a constant-current or constant-voltage source (71) and a line of each selected pair for a period determined by charge or discharge of a capacitance provided in the device;

characterised in that the said individual circuit portions ($70_n$) comprise respective thyristors ($Q_{1n}$, $Q_{2n}$), and in that the said capacitance is provided for each word-line pair (W) by intrinsic capacitance of the thyristor ($Q_{1n}$, $Q_{2n}$) connected therewith, each such thyristor ($Q_{1n}$, $Q_{2n}$) being constructed and connected so as to comprise a PNP transistor ($Q_{1n}$), having an emitter connected to the said one word-line ($W^+$), and an NPN transistor ($Q_{2n}$), having a collector and a base connected to the respective base and collector of the said PNP transistor ($Q_{1n}$), an emitter connected to the said constant-current or constant-voltage source (71), and an additional collector or additional emitter connected to the said other word-line (W⁻).

2. A semiconductor memory device comprising:

a plurality of sets of static-type memory cells (MC);

a plurality of pairs of word-lines (W), which pairs are connected respectively to the said sets of memory cells, one (W⁺) of the lines of each pair being operated at a higher potential than the other (W⁻) when the device is in use; and

word-line discharging circuitry including a plurality of individual circuit portions (130, $Q_{113}$) connected respectively with the word-line pairs (W) and operable to discharge selected word-line pairs (W) by maintaining a connection between a constant-current or constant-voltage source (134) and a line of each selected pair for a period determined by charge or discharge of a capacitance provided in the device;

characterised in that the said individual circuit portions (130, $Q_{113}$) comprise respective thyristors (130), and in that the said capacitance is provided for each word-line pair (W) by intrinsic capacitance of the thyristor (130) connected therewith, each such thyristor (130) being constructed and connected so as to comprise a PNP transistor ($Q_{111}$), having an emitter connected to the said one word-line (W⁺), and a first NPN transistor ($Q_{112}$), having a collector and a base connected to the respective base and collector of the said PNP transistor ($Q_{111}$) and an emitter connected to the said constant-current or constant-voltage source (134), the device being further characterised in that each of the said individual circuit portions (130, $Q_{113}$) further comprises a second NPN transistor ($Q_{113}$) having a base connected to the base of the said first NPN transistor ($Q_{112}$) of the circuit portion concerned, an emitter connected to an additional constant-current or constant-voltage source (135) of the device, and a collector connected to the said other word-line (W⁻).

3. A device as claimed in claim 1 or 2, wherein the said constant-current or constant-voltage source (71; 134) is common to all of the said individual circuit portions ($70_n$; 130, $Q_{113}$).

4. A device as claimed in claim 2, wherein the said additional constant-current or constant-voltage source (135) is common to all of the said individual circuit portions (130, $Q_{113}$).

5. A device as claimed in any preceding claim, wherein the emitter of the said PNP transistor ($Q_{1n}$; $Q_{111}$) is connected to the said one word-line (W⁺) by means of a voltage level shifter ($R_{7n}$; $D_n$; 132) of the device.

6. A device as claimed in claim 5, wherein the said voltage level shifter ($R_{7n}$; $D_n$; 132) comprises a diode ($D_n$).

7. A device as claimed in claim 5, wherein the said voltage level shifter ($R_{7n}$; $D_n$; 132) comprises a resistor ($R_{7n}$; 132).

8. A device as claimed in any preceding claim, wherein each of the said individual circuit portions ($70_n$; 130, $Q_{113}$) further includes a resistor ($R_{12}$) connected between the emitter and the collector of the said PNP transistor ($Q_{1n}$; $Q_{111}$).

9. A device as claimed in any preceding claim, wherein each of the said memory cells (MC) comprises a pair of cross-coupled thyristors ($Q_{83}$, $Q_{85}$; $Q_{84}$, $Q_{86}$).

**Patentansprüche**

1. Halbleiterspeichervorrichtung mit:

einer Vielzahl von Sätzen von statischen Speicherzellen (MC);

einer Vielzahl von Paaren von Wortleitungen (W), welche Paare jeweils mit den genannten Sätzen von Speicherzellen verbunden sind, wobei eine (W⁺) der Leitungen von jedem Paar mit einem höheren Potential als die andere (W⁻) betrieben wird, wenn die Vorrichtung in Betrieb ist; und

einer Wortleitungsentladungsschaltung, die eine Vielzahl von individuellen Schaltungsabschnitten ($70_n$) umfaßt, die jeweils mit den Wortleitungspaaren (W) verbunden und betreibbar sind, um ausgewählte Wortleitungspaare (W) durch Aufrechterhaltung einer Verbindung zwischen einer Konstantstromquelle oder einer Konstantspannungsquelle (71) und einer Leitung von jedem ausgewählten Paar für eine Periode, die durch Ladung oder Entladung der in der Vorrichtung vorgesehenen Kapazität bestimmt ist, zu entladen;

dadurch gekennzeichnet, daß die genannten individuellen Schaltungsabschnitte ($70_n$) jeweils Thyristoren ($Q_{1n}$, $Q_{2n}$) umfassen, und daß die genannte Kapazität für jedes Wortleitungspaar (W) durch materialeigene Kapazität des damit verbundenen Thyristors ($Q_{1n}$, $Q_{2n}$) geliefert wird, wobei jeder solcher Thyristor ($Q_{1n}$, $Q_{2n}$) so konstruiert und angeschlossen ist, daß er einen PNP-Transistor ($Q_{1n}$) umfaßt, der einen Emitter hat, der mit der genannten einen Wortleitung (W⁺) verbunden ist, und einen NPN-Transistor ($Q_{2n}$), der einen Kollektor und eine Basis hat, die mit der Basis bzw. dem Kollektor des genannten PNP-Transistors ($Q_{1n}$) verbunden sind, einen Emitter, der mit der Konstantstromquelle oder Konstantspannungsquelle (71) verbunden ist, und einen zusätzlichen Kollektor oder einen zusätzlichen Emitter, der mit der genannten anderen Wortleitung (W⁻) verbunden ist.

2. Halbleiterspeichervorrichtung mit:

einer Vielzahl von Sätzen von statischen Speicherzellen (MC);

einer Vielzahl von Paaren von Wortleitungen (W), welche Paare jeweils mit den genannten Sätzen von Speicherzellen verbunden sind, wobei eine (W⁺) der Leitungen von jedem Paar mit einem höheren Potential als die andere (W⁻) betrieben wird, wenn die Vorrichtung in Betrieb ist; und

einer Wortleitungsentladungsschaltung, die eine Vielzahl von individuellen Schaltungsabschnitten (130, $Q_{113}$) umfaßt, die jeweils mit den Wortleitungspaaren (W) verbunden und betreibbar sind, um ausgewählte Wortleitungspaare (W) durch Aufrechterhaltung einer Verbindung zwischen einer Konstantstromquelle oder einer Konstantspannungsquelle (134) und einer Leitung von jedem ausgewählten Paar für eine Periode, die durch die Ladung oder Entladung der in der Vorrichtung vorgesehenen Kapazität bestimmt ist, zu entladen;

dadurch gekennzeichnet, daß die individuellen Schaltungsabschnitte (130, $Q_{113}$) jeweils Thyristoren (130) umfassen, und daß die genannte Kapaziät in jedem Wortleitungspaar (W) durch materialeigene Kapazität des damit verbundenen Thyristors (130) geliefert wird, wobei jeder solche Thyristor so konstruiert und angeschlossen ist, daß er einen PNP-Transistor ($Q_{111}$) umfaßt, der einen Emitter hat, der mit der genannten einen Wortleitung ($W^+$) verbunden ist, und einen ersten NPN-Transistor ($Q_{112}$), der einen Kollektor und eine Basis hat, die mit der Basiz bzw. dem Kollektor des genannten PNP-Transistors verbunden sind, und einen Emitter, der mit der genannten Konstantstromquelle oder Konstantspannungsquelle (134) verbunden ist, wobei die Vorrichtung ferner dadurch gekennzeichnet ist, daß jeder der individuellen Schaltungsabschnitte (130, $Q_{113}$) ferner einen zweiten NPN-Transistor ($Q_{113}$) umfaßt, der eine Basis hat, die mit der Basis des genannten ersten NPN-Transistors ($Q_{112}$) des betreffenden Schaltungsabschnitts verbunden ist, einen Emitter, der mit einer zusätzlichen Konstantstromquelle oder Konstantspannungsquelle (135) der Vorrichtung verbunden ist, und einen Kollektor, der mit der genannten anderen Wortleitung ($W^-$) verbunden ist.

3. Vorrichtung nach Anspruch 1 oder 2, bei der die genannte Konstantstromquelle oder Konstantspannungsquelle (71; 134) allen genannten individuellen Schaltungsabschnitten ($70_n$; 130, $Q_{113}$) gemeinsam ist.

4. Vorrichtung nach Anspruch 2, bei der die genannte zusätzliche Konstantstromquelle oder Konstantspannungsquelle (135) allen genannten individuellen Schaltungsabschnitten (130, $Q_{113}$) gemeinsam ist.

5. Vorrichtung nach einem der vorhergehenden Ansprüche, bei der der Emitter des genannten PNP-Transistors ($Q_{1n}$; $Q_{111}$) mit der genannten einen Wortleitung ($W^+$) mittels eines Spannungspegelschiebers ($R_{7n}$; $D_n$; 132) der Vorrichtung verbunden ist.

6. Vorrichtung nach Anspruch 5, bei der der genannten Spannungspegelschieber ($R_{7n}$; $D_n$; 132) eine Diode ($D_n$) umfaßt.

7. Vorrichtung nach Anspruch 5, bei der der genannte Spannungspegelschieber ($R_{7n}$; $D_n$; 132) einen Widerstand ($R_{7n}$; 132) umfaßt.

8. Vorrichtung nach einem der vorhergehenden Ansprüche, bei der jeder der genannten individuellen Schaltungsabschnitte ($70_n$; 130, $Q_{113}$) ferner einen Widerstand ($R_{12}$) umfaßt, der zwischen dem Emitter und dem Kollektor des genannten PNP-Transistors ($Q_{1n}$; $Q_{111}$) verbunden ist.

9. Vorrichtung nach einem der vorhergehenden Ansprüche bei der jede der genannten Speicherzellen (MC) ein Paar von überkreuz gekoppelten Thyristoren ($Q_{83}$; $Q_{85}$; $Q_{84}$, $Q_{86}$) umfaßt.

## Revendications

1. Dispositif de mémoire à semi-conducteur comportant:

plusieurs ensembles de cellules du type statique (MC);

plusieurs paires de lignes de mot (W), ces paires étant connectées respectivement auxdits ensembles de cellules de mémoire, l'une ($W^+$) des lignes de chaque paire étant alimentée à un potentiel supérieur à l'autre ($W^-$) quand le dispositif est en utilisation; et

un circuit de décharge de ligne de mot comprenant plusieurs parties de circuit individuelles ($70_n$) connectées respectivement aux paires de lignes de mot (W) et ayant pour fonction de décharger des paires sélectionnées de lignes de mot (W) en maintenant une connexion entre une source de courant constant ou de tension constante (71) et une ligne de chaque paire sélectionnée pendant une période déterminée par la charge ou la décharge d'une capacité prévue dans le dispositif;

caractérisé en ce que lesdites parties de circuit individuelles ($70_n$) comportent des thyristors respectifs ($Q_{1n}$, $Q_{2n}$) et en ce que ladite capacité est prévue pour chaque paire de lignes de mot (W) par la capacité intrinsèque du thyristor ($Q_{1n}$, $Q_{2n}$) qui lui est connecté, chacun de ces thyristors ($Q_{1n}$, $Q_{2n}$) étant réalisé et connecté de manière à comporter un transistor PNP ($Q_{1n}$) ayant un émetteur connecté à ladite ligne de mot ($W^+$) et une transistor NPN ($Q_{2n}$) ayant un collecteur et une base connectés à la base et au collecteur respectifs dudit transistor PNP ($Q_{1n}$), un émetteur connecté à ladite source de courant constant ou de tension constante (71), et un collecteur supplémentaire ou un émetteur supplémentaire connecté à ladite autre ligne de mot ($W^-$).

2. Dispositif de mémoire à semi-conducteur comportant:

plusieurs ensembles de cellules de mémoire du type statique (MC);

plusieurs paires de lignes de mot (W), ces paires étant connectées respectivement auxdits ensembles de cellules de mémoire, l'une ($W^+$) des lignes de chaque paire étant alimentée à un potentiel supérieur à l'autre ($W^-$) quand le dispositif est en utilisation; et

un circuit de décharge de ligne de mot comprenant plusieurs parties de circuits individuelles (130, $Q_{113}$) connectées respectivement aux paires de lignes de mot (W) et ayant pour fonction de décharger des paires de lignes de mot sélectionnées (W) en maintenant une connexion entre une source de courant constant ou de tension constante (134) et une ligne de chaque paire sélectionnée pendant une période déterminée par la charge ou la décharge d'une capacité prévue dans le dispositif;

caractérisé en ce que lesdites parties de cir-

cuits individuelles (130, $Q_{113}$) comportent des thyristors respectifs (130) et en ce que ladite capacité est produite pour chaque paire de ligne de mot (W) par la capacité intrinsèque du thyristor (130) qui lui est connecté, chacun de ces thyristors (130) étant réalisé et connecté de manière à comporter un transistor PNP ($Q_{111}$) ayant un émetteur connecté à ladite ligne de mot ($W^+$) et un premier transistor NPN ($Q_{112}$) ayant un collecteur et une base connectés à la base et au collecteur respectifs dudit transistor PNP ($Q_{111}$) et un émetteur connecté à ladite source de courant constant ou de tension constante (134), le dispositif étant caractérisé en outre en ce que chacune desdites parties de circuits individuelles (130, $Q_{113}$) comporte en outre un second transistor NPN ($Q_{113}$) ayant une base connectée à la base dudit premier transistor NPN ($Q_{112}$) de la partie de circuit concernée, un émetteur connecté à une autre source de courant constant ou de tension constante (135) du dispositif et un collecteur connecté à ladite autre ligne de mot ($W^-$).

3. Dispositif selon la revendication 1 ou 2 dans lequel ladite source de courant constant ou de tension constante (71; 134) est commune à toutes lesdites parties de circuits individuelles (70$_n$; 130; $Q_{113}$).

4. Dispositif selon la revendication 2, dans lequel ladite autre source de courant constant ou de tension constante (135) est commune à toutes lesdites parties de circuits individuelles (130, $Q_{113}$).

5. Dispositif selon l'une quelconque des revendications précédentes, dans lequel l'émetteur dudit transistor PNP ($Q_{1n}$; $Q_{111}$) est connecté à ladite ligne de mot ($W^+$) au moyen d'un circuit de décalage de niveau de tension ($R_{7n}$; $D_n$; 132) du dispositif.

6. Dispositif selon la revendication 5, dans lequel ledit circuit de décalage de niveau de tension ($R_{7n}$; $D_n$; 132) consiste en une diode ($D_n$).

7. Dispositif selon la revendication 5, dans lequel ledit circuit de décalage de niveau de tension ($R_{7n}$; $D_n$; 132) consiste en une résistance ($R_{7n}$; 132).

8. Dispositif selon l'une quelconque des revendications précédentes, dans lequel chacune desdites parties de circuits individuelles (70$_n$; 130, $Q_{113}$) comporte en outre une résistance ($R_{12}$) connectée entre l'émetteur et le collecteur dudit transistor PNP ($Q_{1n}$; $Q_{111}$).

9. Dispositif selon l'une quelconque des revendications précédentes, dans lequel chacune desdites cellules de mémoire (MC) consiste en une paire de thyristors couplés en croix ($Q_{83}$, $Q_{85}$; $Q_{84}$, $Q_{86}$).

## Fig. 1

## Fig. 2

## Fig. 3A

## Fig. 3B

## Fig. 4 A

## Fig. 4B

## Fig. 5

## Fig. 6

## Fig. 7

## Fig. 8

# Fig. 9

# Fig. 10

## Fig. 11

## Fig. 12

Fig. 13

EP 0 100 160 B1